# EUROPÄISCHE PATENTSCHRIFT

(11) **EP 0 437 551 B1**
(45) Veröffentlichungstag und Bekanntmachung des Hinweises auf die Patenterteilung: **12.10.1994**
(21) Anmeldenummer: 90906899.1
(22) Anmeldetag: 17.05.1990
(51) Int. Cl.: G01R 31/00, G07C 5/10

(54) **VERFAHREN UND VORRICHTUNG ZUM ABFRAGEN VON STEUERGERÄTE-DATEN**
PROCESS AND DEVICE FOR POLLING CONTROL UNIT DATA
PROCEDE ET DISPOSITIF POUR L'INTERROGATION DE DONNEES PROVENANT D'APPAREILS DE COMMANDE

(30) Priorität: 08.08.1989 DE 3926097
(43) Veröffentlichungstag der Anmeldung: 24.07.1991
(73) Patentinhaber: ROBERT BOSCH GMBH, 70442 Stuttgart (DE)
(72) Erfinder: PRZYBYLA, Bernd, D-7141 Schwieberdingen (DE); PALESCH, Reinhard, D-7147 Eberdingen-Hochdorf (DE)
(86) Internationale Anmeldenummer: DE9000368
(87) Internationale Veröffentlichungsnummer: WO9102256

(56) Entgegenhaltungen:
- EP-A- 0 225 971
- EP-A- 0 266 704
- EP-A- 0 303 059
- WO-A-86/01620
- WO-A-88/02122
- DE-A- 3 309 920
- DE-A- 3 806 794

## Beschreibung

Die Erfindung geht aus von einem Verfahren und einer Vorrichtung zur Überprüfung von Steuergeräten eines Kraftfahrzeuges mit Hilfe eines externen Testgerätes nach der Gattung des Hauptanspruchs. In heute gebräuchlichen Fahrzeugen sind gewöhnlich mehrere elektronische Steuergeräte vorgesehen, die spezifische Arbeits- und Sicherheitsfunktionen beim Betrieb des Fahrzeugs erfüllen. Derartige Steuergeräte dienen beispielsweise zur Steuerung und/oder Regelung der Zündung, der Kraftstoffzuführung, des Getriebes, der Verhinderung eines Schlupfes, der Leistung, des Abgases, des Bremsvorgangs und dgl. Derartige Steuergeräte sind in bekannter Weise über eine gemeinsame Kommunikationsleitung miteinander verbunden, an der eine Diagnoseschnittstelle bzw. ein Diagnoseanschluß vorgesehen ist. Über ein an die Diagnoseschnittstelle angeschlossenes Testgerät sollen die Funktion und der ordnungsgemäße Zustand der einzelnen Steuergeräte überprüft werden. Um mit den einzelnen Steuergeräten in Verbindung treten zu können, ist es erforderlich, die Adressen der einzelnen Steuergeräte zu kennen. Weiterhin ist es erforderlich, zu wissen, ob ein jeweiliges Steuergerät überhaupt im zu testenden Fahrzeug vorhanden ist. Diese Informationen müssen entweder der Bedienungsperson bekannt sein oder sie sind im Testgerät abgelegt, wobei dann jedoch das Testgerät nur für ganz spezifische Fahrzeugtypen verwendbar wäre. Eine automatische Erkennung von vorhandenen Steuergeräten und ein automatischer Zugriff zu diesen stellt ein nicht triviales Problem für die Logistik dar und überfordert die Möglichkeiten eines einfachen Handtestgeräts. Andererseits wäre die Eingabe von jeweiligen Adressen eine sehr umständliche Methode für die Kommunikation zu den einzelnen Steuergeräten, wobei eine Vielzahl zu aktualisierender Listen und Tabellen erforderlich wäre. Dies umso mehr, wenn das Testgerät für eine Vielzahl verschiedener Fahrzeugtypen und -Marken eingesetzt werden soll.

Aus der WO 88/02122 ist ein Diagnosesystem für Steuergeräte eines Kraftfahrzeuges bekannt. Dabei können mehrere Steuergeräte im Kraftfahrzeug verbaut sein. Die Diagnose jedes einzelnen Steuergerätes findet mit Hilfe eines externen Diagnosegerätes statt. Dazu weist jedes Steuergerät einen eigenen Diagnoseanschluß auf. Sobald das Diagnosegerät an ein einzelnes Steuergerät angeschlossen ist und die Betriebsspannung für das Steuergerät angeschaltet wird, gibt dieses Steuergerät einen Identifikations-Code an das Diagnosegerät aus. Mit dem Identifikations-Code teilt das Steuergerät dem Diagnosegerät mit, welcher Art das angeschlossene Steuergerät ist. Das Diagnosegerät wählt dann aufgrund des Identifikations-Codes das für dieses Steuergerät geeignete Prüfprogramm aus. Sodann folgt der Test des Steuergerätes nach diesem Prüfprogramm.

Die EP 0 266 704 A2 beschreibt die Programmierung der Speicher von Steuergeräten eines Kraftfahrzeuges am Bandende der Produktion des Kraftfahrzeuges. Dabei werden einzelne Steuergeräte mit den fahrzeugspezifischen Daten programmiert. Dadurch soll der Fertigungsprozeß vereinfacht werden. Die einzelnen Steuergeräte können dabei über Diagnoseleitungen miteinander verbunden sein. Für die Übertragung der zu programmierenden Daten zu den einzelnen Steuergeräten werden die Diagnoseleitungen verwendet.

Es ist Aufgabe der Erfindung, sicherzustellen, daß kein einzelnes Steuergerät eines Kraftfahrzeuges bei einer Diagnose des Kraftfahrzeuges z.B. in einer Reparaturwerkstatt übersehen wird.

Diese Aufgabe wird durch die Merkmale der Ansprüche 1 und 9 gelöst.

### Vorteile der Erfindung

Das erfindungsgemäße Verfahren mit den kennzeichnenden Merkmalen des Hauptanspruchs hat den Vorteil, daß mit einem relativ einfach aufgebauten Testgerät, insbesondere auch einem Handtestgerät, ohne Vorkenntnisse der Bedienperson über das jeweilige Fahrzeug automatisch festgestellt werden kann, welche Steuergeräte in diesem Fahrzeug vorhanden sind und wie mit ihnen automatisch ein Verbindung herstellbar ist. Auf diese Art und Weise ist sichergestellt, daß kein einzelnes Steuergerät bei der Diagnose übersehen wird, selbst dann nicht, wenn es auf einen Reizvorgang aufgrund eines Defektes nicht reagiert. Das Verfahren ist insbesondere für nicht herstellergebundene Werkstätten von Vorteil, da dort nicht alle Informationen über die Vielzahl verschiedener Kraftfahrzeugtypen und -Marken vorliegen. Nachträgliche Änderungen, insbesondere nachgerüstete zusätzliche Steuergeräte, können ohne besondere Maßnahmen erkannt und diagnostiziert werden. Auch für Fahrzeuge, bei denen der Ausstattungsgrad an Steuergeräten sehr stark vom individuellen Kundenwunsch abhängt, erweist sich das erfindungsgemäße Verfahren als besonders geeignet. Auch Kombinationen von Steuergeräten, die zum Zeitpunkt der Herstellung eines Testgerätes noch nicht üblich oder vorgesehen waren, können ohne Probleme getestet werden.

Durch die in den Unteransprüchen aufgeführten Maßnahmen sind vorteilhafte Weiterbildungen und Verbesserungen des im Hauptanspruch angegebenen Verfahrens möglich.

Eine besonders einfache Art des genormten Zugriffs besteht darin, daß dieser über eine fest vereinbarte Adresse erfolgt, unabhängig vom Ausstattungsgrad, vom Typ oder der Marke des einzelnen Fahrzeugs. Hierdurch ist eine Kommunikation des Testgeräts mit jedem beliebigen Fahrzeug möglich.

Die Abfrage der einzelnen Steuergeräte erfolgt in vorteilhafter Weise ebenfalls über jeweils zugeordnete Adressen, die zuvor aus der zentralen Stelle abgefragt werden. Die Zugriffsinformationen liegen somit nicht im Testgerät selbst, sondern in der zentralen Stelle des jeweiligen Fahrzeugs.

Die Abfrage der einzelnen Steuergeräte kann auch über Umschaltbefehle für eine alternativ die einzelnen Steuergeräte mit dem Testgerät verbindende Umschalteinrichtung erfolgen, wobei diese Umschaltbefehle ebenfalls zuvor aus der zentralen Stelle abgefragt werden.

Weiterhin vorteilhaft ist, daß die erforderliche Hinterlegung der Daten über die Art und/oder Adressierung der vorhandenen Steuergeräte in der zentralen Stelle im technisch einfachsten Fall durch Einprogrammierung während der Montage oder Endprüfung des Fahrzeuges erfolgen kann.

Es ist jedoch auch möglich, daß die verschieden ausgeführten Codier-Pins von Steuergerätesteckern von der zentralen Stelle abgefragt und entsprechende Daten über die jeweiligen Steuergeräte dort abgespeichert werden.

Eine andere Möglichkeit ist, daß die installierten Steuergeräte sich über einen Kommunikationsbus der zentralen Stelle melden und daraufhin Daten über die jeweiligen Steuergeräte dort abgespeichert werden.

Schließlich besteht noch die besonders komfortable Möglichkeit, daß ein immer vorhandenes die zentrale Stelle enthaltendes und mit den anderen Steuergeräten zusammenwirkendes Steuergerät Steuer- und/oder Abfragesignale der angeschlossenen anderen Steuergeräte registriert und in Abhängigkeit davon die Art dieser Steuergeräte erkennt und entsprechende Daten an der zentralen Stelle abspeichert. Bei der zuletzt genannten Alternative sind keinerlei besondere zusätzliche hardwaremäßige Voraussetzungen erforderlich und es erfolgt eine automatische Anpassung der Diagnose auch bei nachträglichen Veränderungen oder Ergänzungen von Steuergeräten.

Eine besonders geeignete Vorrichtung zur Durchführung des Verfahrens besteht darin, daß ein Informationen über die Art und Anzahl und/oder deren Ansprechadressen enthaltender und durch das Testgerät abfragbarer nichtflüchtiger Speicher vorgesehen ist. Dieser Speicher kann in einem immer vorhandenen Steuergerät für wesentliche Funktionen des Fahrzeugs angeordnet sein, beispielsweise in einem Zünd- und/oder Einspritz-Steuergerät oder der Speicher ist in einem gesonderten Schnittstellenumsetzer in der Kommunikationsleitung zum Diagnoseanschluß angeordnet.

Dieser nichtflüchtige Speicher kann auch die entsprechenden Umschaltsignale für eine die einzelnen Steuergeräte alternativ mit dem Testgerät verbindende Umschalteinrichtung, die zwischen dem Diagnoseanschluß und den Steuergeräten oder in der Zuleitung des Testgeräts zum Diagnoseanschluß vorgesehen sein kann.

Eine weitere Alternative ist, daß in der Vorrichtung wenigstens ein Steuergerätestecker vorgesehen ist, der mit abfragbaren und Informationen über den Ausstattungsgrad enthaltenden Codier-Pins versehen ist. Dadurch kann das Steuergerät, das mit diesem Steuergerätestecker verbunden ist, die entsprechenden Informationen auslesen.

### Zeichnung

Drei Ausführungsbeispiele der Erfindung sind in der Zeichnung dargestellt und in der nachfolgenden Beschreibung näher erläutert. Es zeigen:
- Fig. 1: ein Blockschaltbild eines ersten Ausführungsbeispiels der Erfindung, bei dem der nichtflüchtige Speicher in einem immer vorhandenen Steuergerät vorgesehen ist,
- Fig. 2: ein Blockschaltbild eines zweiten Ausführungsbeispiels der Erfindung, bei dem der nichtflüchtige Speicher in einem Schnittstellenumsetzer angeordnet ist, und
- Fig. 3: ein Blockschaltbild eines dritten Ausführungsbeispiels der Erfindung mit einer Umschalteinrichtung.

### Beschreibung der Ausführungsbeispiele

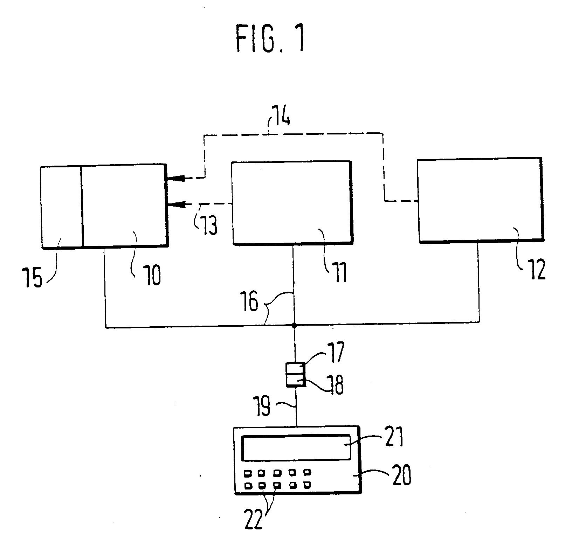

Bei dem in Fig. 1 dargestellten ersten Ausführungsbeispiel sind drei elektronische Steuergeräte 10 bis 12 in einem nicht dargestellten Fahrzeug angeordnet. Dabei ist das Steuergerät 10 ein in jeder Ausführung und Ausbaustufe des jeweiligen Fahrzeugs vorhandenes Steuergerät, also beispielsweise ein Zünd- und/oder Einspritzsteuergerät. Die anderen beiden Steuergeräte können beispielsweise Steuergeräte zur Steuerung und/oder Regelung des Getriebes, der Verhinderung des Schlupfes, der Leistung od.dlg. sein. Durch die gestrichelt dargestellten Leitungen 13,14 soll die Einwirkung der Steuergeräte 11,12 auf das Steuergerät 10 gezeigt werden. Beispielsweise erfolgt beim Auftreten eines Schlupfes in bekannter Weise eine Beeinflussung der Zündung und/oder Kraftstoffeinspritzung zur Reduzierung der Leistung. In ähnlicher Weise erfolgt beim Schalten eines Getriebes eine entsprechende Einwirkung zur Reduzierung oder Erhöhung des Drehmoments. Diese Steuergeräte weisen gewöhnlich Mikrorechner auf, wobei die Leitungen 13,14 als Daten- bzw. Adreßbus ausgebildet sein können.

Das immer vorhandene Steuergerät 10 enthält einen nichtflüchtigen Speicher 15 zur Speicherung der Art der übrigen Steuergeräte 11,12 sowie deren Ansprechadressen.

Die drei Steuergeräte 10 bis 12 sind über Kommunikationsleitungen 16 untereinander und mit einem Diagnoseanschluß 17 verbunden. Derartige Kommunikationsleitungen sind gewöhnlich als genormter Diagnosebus ausgebildet, der in üblicher Weise aus einer sogenannten K- und einer L-Leitung besteht. Alternativ ist ein Kommunikationsbus wie z.B. der bekannte CAN-Bus hierfür einsetzbar. In den Diagnoseanschluß 17 ist ein Diagnosestecker 18 an einer Diagnoseleitung 19 einsteckbar, die mit einem Testgerät 20 zur Diagnose und Fehlererkennung der angeschlossenen Steuergeräte 10 bis 12 verbunden ist. Das Testgerät 20 weist ein Display 21 sowie eine Bedienungstastatur 22 auf.

Zur Diagnose wird der Diagnosestecker 18 mit dem Diagnoseanschluß 17 verbunden. Nun kann das dadurch angeschlossene Testgerät 20 über eine fest vereinbarte, genormte Adresse mit dem Steuergerät 10 in Verbindung treten und neben den Diagnoseinformationen über dieses Steuergerät 10 dort aus dem nichtflüchtigen Speicher 15 die Daten über die Art der übrigen vorhandenen Steuergeräte 11 und 12 sowie die zugeordneten Ansprechadressen entnehmen. Im dargestellten Falle sind im nichtflüchtigen Speicher 15 zwei Adressen für die beiden Steuergeräte 11 und 12 sowie die Information enthalten, daß zwei weitere Steuergeräte angeschlossen sind, z.B. ein Getriebe-Steuergerät und ein Steuergerät für die Antischlupfregelung (ASR). Nun kann das Testgerät 20 manuell oder automatisch gesteuert nacheinander mit diesen weiteren Steuergeräten 11,12 über die ausgelesenen Adressen in Verbindung treten und die jeweiligen Diagnoseinformationen entnehmen.

Die Daten über die Art der weiteren Steuergeräte und deren Ansprechadressen werden in den nichtflüchtigen Speicher 15 beispeilsweise während des Herstellungsprozesses oder in der Endprüfphase der elektronischen Anlage eingespeichert. Wird später ein zusätzliches Steuergerät für eine weitere Funktion eingebaut oder ein vorhandenes Steuergerät ausgebaut, so müssen die Daten im nichtflüchtigen Speicher 15 entsprechend angepaßt werden, um die weitere Diagnose sicher zustellen.

Eine weitere Möglichkeit, diese Daten in den nichtflüchtigen Speicher 15 einzugeben, besteht darin, daß das Steuergerät 10 über Gerätestecker verbunden ist, die eine oder mehrere Codier-Pins aufweisen. Die Information dieser Codier-Pins gibt den Ausstattungsgrad des Fahrzeugs wieder. Typisch wird die Codierung am Bandende des Fahrzeugherstellers vorgenommen. Im Steuergerät 10 ist es nun lediglich erforderlich, die Codier-Anschlüsse abzufragen und entsprechend den vorhandenen Codier-Pins der Gerätestecker Daten über die weiteren angeschlossenen Steuergeräte und deren entsprechende Adressen im nichtflüchtigen Speicher 15 einzuspeichern.

Weiterhin können Daten über die angeschlossenen Steuergeräte 11,12 auch automatisch über eine Lerneinrichtung im Steuergerät 10 erfaßt werden. Dies erfolgt dadurch, daß die weiteren Steuergeräte 11,12 zyklisch oder nichtzyklisch Steuerinformationen über die gestrichelt dargestellten Leitungen 13 und 14 an das Steuergerät 10 senden. Das Auftreten dieser Steuerinformationen wird von der Lerneinrichtung überwacht, wobei in Abhängigkeit der eingehenden Signale das entsprechende, sendende Steuergerät erkannt wird, so daß die entsprechenden Daten und Adressen in den nichtflüchtigen Speicher 15 automatisch eingegeben werden können. Dieses Verfahren hat den Vorteil, daß ein gesonderter Einspeichervorgang in den nichtflüchtigen Speicher 15 während des Fertigungsprozesses nicht mehr erforderlich ist, sondern daß die erforderlichen Daten für das Testgerät 20 automatisch über das Lernverfahren erfaßt werden. Diese Daten können dabei entweder in anderen Speicherbereichen des nichtflüchtigen Speichers 15 bereits enthalten sein, so daß sie nur noch in den aktuellen Zugriffsspeicherbereich umgespeichert werden müssen. Sind die Steuergeräte über einen Kommunikationsbus (z.B. CAN) verbunden, so können die erforderlichen Daten und Adressen über diesen an das zentrale Steuergerät übergeben und dort im Speicher 15 abgespeichert werden.

An allen diesen Verfahren, Daten und Adressen der vorhandenen Steuergeräte in den nichtflüchtigen Speicher 15 einzugeben, ist das Testgerät 20 selbst nicht beteiligt, so daß ein einfaches Handtestgerät mit einfacher Logistik eingesetzt werden kann.

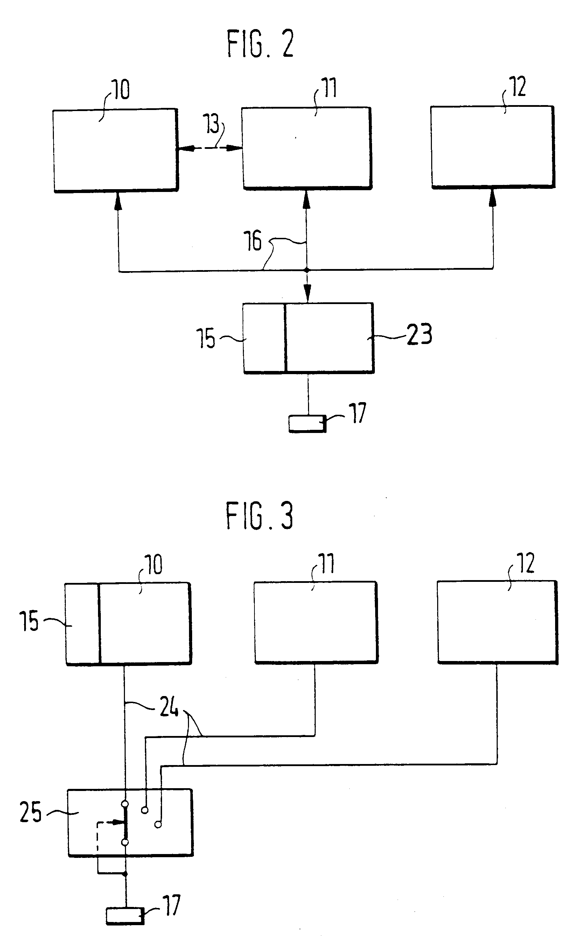

Das in Fig. 2 dargestellte zweite Ausführungsbeispiel entspricht weitgehend dem ersten Ausführungsbeispiel, gleiche Bauteile und Baugruppen sind mit denselben Bezugszeichen versehen und nicht nochmals beschrieben. Im Unterschied zum ersten Ausführungsbeispiel ist nunmehr der nichtflüchtige Speicher 15 in einem Schnittstellenumsetzer 23 eingebaut, der zwischen den Diagnoseanschluß 17 und die Kommunikationsleitungen 16 geschaltet ist. Das Steuergerät 12 beeinflußt bei diesem Ausführungsbeispiel das Steuergerät 10 nicht über die Leitung 14, sondern gegebenenfalls über die Kommunikationsleitung 16.

Für das nicht dargestellte, an den Diagnoseanschluß 17 anschließbare Testgerät 20 ergeben sich kaum veränderte Verhältnisse. Über die genormte Adresse tritt das Testgerät 20 zunächst in Kontakt mit dem nichtflüchtigen Speicher 15 im Schnittstellenumsetzer 23 und erfährt dort in ähnlicher Weise die Art und die Adressen der angeschlossenen Steuergeräte 10 bis 12, wobei der anschließende Diagnosekontakt mit diesen Steuergeräten über den Schnittstellenumsetzer 23 erfolgt. Die Einspeicherung der erforderlichen Daten in den nichtflüchtigen Speicher 15 kann nach einem der beschriebenen Verfahren zum ersten Ausführungsbeispiel erfolgen, sofern die jeweils dort genannten Voraussetzungen erfüllt sind.

Der Schnittstellenumsetzer muß nicht per Prinzip ein eigenständiges Gerät darstellen, sondern kann Bestandteil des immer verbauten und damit zentralen Steuergerätes sein.

Bei dem in Fig. 3 dargestellten dritten Ausführungsbeispiel sind die drei Steuergeräte 10 bis 12 über Kommunikationsleitungen 24 mit einer Umschalteinrichtung 25 verbunden, durch die diese Steuergeräte 10 bis 12 alternativ mit dem Diagnoseanschluß 17 verbindbar sind. Im Anfangszustand ist der Diagnoseanschluß 17 und damit auch das nicht dargestellte anschließbare Testgerät 20 mit dem Steuergerät 10 verbunden, das den nichtflüchtigen Speicher 15 enthält. Aus diesem können in der beschriebenen Weise die Daten für die übrigen Steuergeräte 11 und 12 ausgelesen werden. Anstelle von Adressen können hier auch Umschaltbefehle für die Umschalteinrichtung 25 dienen, über die vom Testgerät 20 manuell oder automatisch gesteuert die gewünschte Umschaltung auf die übrigen Steuergeräte 11 und 12 vorgenommen wird. Dies kann selbstverständlich auch über Adressen erfolgen.

In Abwandlung des in Fig. 3 dargestellten Ausführungsbeispiels kann die Umschalteinrichtung 25 auch zwischen dem Diagnoseanschluß 17 und dem Testgerät 20 angeordnet sein, z.B. auch im Testgerät 20 selbst eingebaut sein. Eine solche Anordnung kann z.B. dann erforderlich sein, wenn die Kommunikationsleitungen 24 separat zum Diagnoseanschluß 17 geführt sind. Auch bei einer solchen Ausführung erfolgt zunächst ein Zugriff über die genormte Adresse, und es werden die Daten der Steuergeräte aus dem nichtflüchtigen Speicher 15 ausgelesen. Entsprechend kann dann eine Umschaltung der Umschalteinrichtung 25 vom Testgerät 20 aus gesteuert werden, wobei die einzelnen Steuergeräte direkt oder über ausgelesene Adressen zur Diagnose angesprochen werden.

Die Zahl der angeschlossenen Steuergeräte ist selbstverständlich nicht auf die Zahl drei beschränkt, sondern kann auch wesentlich größer sein. Da die Informationen über diese Steuergeräte im nichtflüchtigen Speicher 15, also außerhalb des Testgeräts 20, liegen, ist die Zahl der angeschlossenen Steuergeräte für den Aufbau des Testgeräts 20 prinzipiell nicht von Bedeutung.

## Patentansprüche

1. Verfahren zur Überprüfung von Steuergeräten eines Kraftfahrzeuges mit Hilfe eines externen Testgerätes, wobei das Testgerät an einen Diagnoseanschluß des Kraftfahrzeuges angeschlossen wird, wobei das Testgerät Diagnosedaten oder Zustandsdaten von jedem einzelnen Steuergerät abfragt, dadurch gekennzeichnet, daß an einer zentralen Stelle (15) im Kraftfahrzeug, die über den Diagnoseschluß (17) abfragbar ist, Informationen über die Art und Zahl der im Kraftfahrzeug eingebauten Steuergeräte (10 bis 12) abgespeichert werden, daß zunächst von dem Testgerät (20) die Informationen über die Art und Zahl der im Kraftfahrzeug eingebauten Steuergeräte (10 bis 12) über einen genormten Zugriff von der zentralen Stelle (15) abgerufen werden und daß anschließend mittels der erhaltenen Informationen über die Art und Zahl der im Kraftfahrzeug eingebauten Steuergeräte (10 bis 12) in automatischer Reihenfolge oder manuell gesteuert auf die einzelnen Steuergeräte (10 bis 12) zugegriffen wird, um die Diagnosedaten oder Zustandsdaten von jedem einzelnen Steuergerät abzufragen.

2. Verfahren nach Anspruch 1, dadurch gekennzeichnet, daß der genormte Zugriff ein Zugriff über eine fest vereinbarte Adresse ist.

3. Verfahren nach Anspruch 1 oder 2, dadurch gekennzeichnet, daß die Abfrage der einzelnen Steuergeräte (10 bis 12) über zugeordnete Adressen erfolgt, die zuvor aus der zentralen Stelle (15) abgefragt wurden.

4. Verfahren nach Anspruch 1 oder 2, dadurch gekennzeichnet, daß die Abfrage der einzelnen Steuergeräte (10 bis 12) über Umschaltbefehle für eine alternativ die einzelnen Steuergeräte mit dem Testgerät (20) verbindende Umschalteinrichtung (25) erfolgt, wobei diese Umschaltbefehle zuvor aus der zentralen Stelle (15) abgefragt werden.

5. Verfahren nach einem der vorhergehenden Ansprüche, dadurch gekennzeichnet, daß die Hinterlegung der Informationen über die Art und Zahl der im Kraftfahrzeug eingebauten Steuergeräte (10 bis 12) in der zentralen Stelle (15) durch Einprogrammierung während der Montage oder Endprüfung des Kraftfahrzeuges erfolgt.

6. Verfahren nach einem der Ansprüche 1 bis 4, dadurch gekennzeichnet, daß über Codier-Pins an Steuergerätesteckern eines zentralen Steuergerätes (10), welches diese abfragt, der Ausstattungsgrad erkannt wird und entsprechende Daten über die jeweiligen Steuergeräte (10 bis 12) dort gespeichert werden.

7. Verfahren nach einem der Ansprüche 1 bis 4, dadurch gekennzeichnet, daß die installierten Steuergeräte (10 bis 12) sich über einen Kommunikationsbus der zentralen Stelle (15) melden und daraufhin Daten über die jeweiligen Steuergeräte (10 bis 12) dort gespeichert werden.

8. Verfahren nach einem der Ansprüche 1 bis 4, dadurch gekennzeichnet, daß ein immer vorhandenes, die zentrale Stelle (15) enthaltendes und mit den anderen Steuergeräten (11, 12) zusammenwirkendes Steuergerät (10) Steuer- und/oder Abfragesignale der angeschlossenen anderen Steuergeräte (11, 12) registriert und in Abhängigkeit davon die Art dieser Steuergeräte (11, 12) erkennt und entsprechende Daten an der zentralen Stelle (15) abspeichert.

9. Vorrichtung zur Durchführung des Verfahrens nach einem der vorhergehenden Ansprüche, wobei in einem Kraftfahrzeug eine Anzahl von Steuergeräten eingebaut sind, das Kraftfahrzeug einen Diagnoseanschluß enthält, an den ein Testgerät anschließbar ist, dadurch gekennzeichnet, daß der Diagnoseanschluß (17) über mindestens eine Kommunikationsleitung (16) mit den einzelnen Steuergeräten (10 bis 12) verbunden ist, daß ein nichtflüchtiger Speicher (15) im Kraftfahrzeug vorgesehen ist, in dem Informationen über die Art und Anzahl der im Kraftfahrzeug verbauten Steuergeräte (10 bis 12) und/oder deren Ansprechadressen abgespeichert sind und daß der nichtflüchtige Speicher (15) durch das Testgerät (20) abfragbar ist.

10. Vorrichtung nach Anspruch 9, dadurch gekennzeichnet, daß der nichtflüchtige Speicher (15) in einem immer vorhandenen Steuergerät (10) für wesentliche Funktionen des Fahrzeuges oder in einem Schnittstellenumsetzer (23) in der Kommunikationsleitung zum Diagnoseanschluß (17) angeordnet ist.

11. Vorrichtung nach Anspruch 9 oder 10, dadurch gekennzeichnet, daß eine die einzelnen Steuergeräte (10 bis 12) alternativ mit dem Testgerät (20) verbindende Umschalteinrichtung (25) vorgesehen ist.

12. Vorrichtung nach Anspruch 11, dadurch gekennzeichnet, daß die Umschalteinrichtung (25) zwischen dem Diagnoseanschluß (17) und den Steuergeräten (10 bis 12) oder in der Zuleitung des Testgeräts (20) zum Diagnoseanschluß (17) vorgesehen ist.

13. Vorrichtung nach einem der Ansprüche 9 bis 12, dadurch gekennzeichnet, daß wenigstens ein Steuergerätestecker vorgesehen ist, der mit abfragbaren und Informationen über den Ausstattungsgrad enthaltenden Codier-Pins versehen ist.

## Claims

1. A method for testing motor vehicle control devices with the aid of an external test set, the test set being connected to a diagnostic connection on the motor vehicle, the test set interrogating diagnostic data or condition data of each individual control device, wherein, at a central location (15) in the motor vehicle, which location may be interrogated via the diagnostic connection (17), information about the type and number of the control devices (10 through 12) built into the vehicle is stored, wherein, firstly, the information about the type and number of the control devices (10 through 12) built into the vehicle is called up by the test set (20) via a standardized access from the central location (15) and wherein subsequently, by means of the information obtained about the type and number of the control devices (10 through 12) built into the motor vehicle, the individual control devices (10 through 12) are accessed in automatic sequence or under manual control, in order to interrogate the diagnostic data or condition data of each individual control device.

2. The method as claimed in claim 1, wherein the standardized access is an access via an address which is permanently agreed.

3. The method as claimed in claim 1 or 2, wherein the interrogation of the individual control devices (10 through 12) takes place via assigned addresses, which have previously been interrogated from the central location (15).

4. The method as claimed in claim 1 or 2, wherein the interrogation of the individual control devices (10 through 12) takes place via change-over commands for a change-over apparatus (25) which connects the individual control devices alternatively to the test set (20), these change-over commands having previously been interrogated from the central location (15).

5. The method as claimed in one of the preceding claims, wherein the storage in the central location (15) of the information about the type and number of the control devices (10 through 12) built into the motor vehicle is carried out by programming-in during the assembly or final testing of the motor vehicle.

6. The method as claimed in one of claims 1 to 4, wherein the level of equipment is recognized by means of coding pins in control device plugs of a central control device (10), which interrogates the said pins, and corresponding data about the respective control devices (10 through 12) are stored therein.

7. The method as claimed in one of claims 1 to 4, wherein the installed control devices (10 through 12) report to the central location (15) via a communications bus, and data are thereupon stored there about the respective control devices (10 through 12).

8. The method as claimed in one of claims 1 to 4, wherein a control device (10), which is always available, contains the central location (15) and interacts with the other control devices (11, 12), records control and/or interrogation signals of the other connected control devices (11, 12) and, as a function of these signals, recognizes the type of these control devices (11, 12) and stores corresponding data at the central location (15).

9. A device for carrying out the method as claimed in one of the preceding claims, a number of control devices being built into a motor vehicle, the motor vehicle containing a diagnostic connection to which a test set may be connected, wherein the diagnostic connection (17) is connected to the individual control devices (10 through 12) via at least one communications lead (16), wherein the motor vehicle is provided with a non-volatile memory (15) in which information about the type and number of the control devices (10 through 12) built into the motor vehicle and/or their response addresses are stored and wherein the non-volatile memory (15) may be interrogated by the test set (20).

10. The device as claimed in claim 9, wherein the non-volatile memory (15) is arranged in a control device (10), which is always available, for important functions of the motor vehicle or in an interface converter (23) in the communications lead to the diagnostic connection (17).

11. The device as claimed in claim 9 or 10, wherein one change-over apparatus (25), which connects the individual control devices (10 through 12) alternatively to the test set (20), is provided.

12. The device as claimed in claim 11, wherein the change-over apparatus (25) is provided between the diagnostic connection (17) and the control devices (10 through 12) or in the lead in from the test set (20) to the diagnostic connection (17).

13. The device as claimed in one of claims 9 to 12, wherein at least one control device plug is provided which is provided with coding pins which may be interrogated and contain information about the level of equipment.

## Revendications

1. Procédé pour la vérification d'appareils de commande d'un véhicule automobile à l'aide d'un appareil externe de contrôle, cet appareil de contrôle étant raccordé à un raccordement de diagnostic du véhicule automobile, tandis que l'appareil de contrôle demande à chaque appareil de commande individuel des données de diagnostic ou bien des données d'état, caractérisé en ce que des informations sur le type et le nombre des appareils de commande (10 à 12) installés dans le véhicule automobile sont mémorisées, dans un poste central (15) du véhicule automobile, poste susceptible d'être interrogé par l'intermédiaire du raccordement de diagnostic (17), en ce que tout d'abord à partir de l'appareil de contrôle (20) les informations sur le type et le nombre des appareils de commande (10 à 12) montés dans le véhicule automobile sont appelées par l'intermédiaire d'un accès normalisé à partir du poste central (15) et qu'ensuite au moyen des informations obtenues sur le type et le nombre des appareils de commande (10 à 12) montés dans le véhicule automobile, il accède aux différents appareils de commande (10 à 12), selon une succession automatique ou bien par commande manuelle pour interroger les données du diagnostic ou les données d'état de chaque appareil de commande individuel.

2. Procédé selon la revendication 1, caractérisé en ce que l'accès normalisé est un accès par l'intermédiaire d'une adresse bien spécifiée.

3. Procédé selon la revendication 1 ou la revendication 2, caractérisé en ce que l'interrogation des différents appareils de commande (10 à 12) s'effectue par l'intermédiaire des adresses qui leur sont attribuées, qui sont tout d'abord extraites du poste central (15).

4. Procédé selon la revendication 1 ou la revendication 2, caractérisé en ce que l'interrogation des différents appareils de commande (10 à 12) s'effectue par l'intermédiaire d'ordres de commutation pour un dispositif de commutation (25) reliant alternativement les différents appareils de commande à l'appareil de contrôle (20), ces ordres de commutation étant préalablement extraits du poste central (15).

5. Procédé selon une des précédentes revendications, caractérisé en ce que le dépôt des informations sur le type et le nombre des appareils de commande (10 à 12) montés dans le véhicule automobile s'effectue dans le poste central (15) par programmation pendant le montage ou le contrôle final du véhicule automobile.

6. Procédé selon une des revendications 1 à 4, caractérisé en ce que par l'intermédiaire de broches de codage sur les fiches d'un appareil de commande centrale (10), qui interroge ces broches, le degré d'équipement est reconnu et des données correspondantes sur les appareils de commande respectifs (10 à 12) sont mémorisées.

7. Procédé selon une des revendications 1 à 4, caractérisé en ce que les appareils de commande à installer (10 à 12) s'annoncent au poste central (15) par l'intermédiaire d'un bus de communication et qu'ensuite, des données sur les appareils de commande respectifs (10 à 12) sont mémorisées.

8. Procédé selon une des revendications 1 à 4, caractérisé en ce qu'un appareil de commande (10) toujours présent, contenant le poste central (15) et coopérant avec les autres appareils de commande (11, 12) enregistre des signaux de commande et/ou des signaux d'interrogation des autres appareils de commande raccordés (11, 12) et en fonction de ces signaux reconnaît le type de ces appareils de commande (11, 12) et mémorise au poste central (15) des données correspondantes.

9. Dispositif pour la mise en oeuvre du procédé selon une des précédentes revendications, dispositif dans lequel un certain nombre d'appareils de commande sont montés dans un véhicule automobile, le véhicule automobile comprend un raccordement de diagnostic auquel est susceptible d'être raccordé un appareil de contrôle, caractérisé en ce que le raccordement de diagnostic (17) est relié par l'intermédiaire d'au moins une ligne de communication (16) avec les différents appareils de commande (10 à 12), en ce qu'il est prévu une mémoire non volatile (15), dans laquelle sont mémorisées des informations sur le type et le nombre des appareils de commande (10 à 12) montés dans le véhicule automobile et/ou leurs adresses sont mémorisées et en ce que la mémoire non volatile (15) est susceptible d'être interrogée par l'appareil de contrôle (20).

10. Dispositif selon la revendication 9, caractérisé en ce que la mémoire non volatile (15) est disposée dans un appareil de commande (10) toujours présent pour des fonctions essentielles du véhicule ou bien dans un convertisseur d'interfaces (23) sur la ligne de communication vers le raccordement de diagnostic (17).

11. Dispositif selon la revendication 9 ou la revendication 10, caractérisé en ce qu'il est prévu un dispositif de commutation (25) reliant alternativement avec l'appareil de contrôle (20) les appareils de commande individuelle (10 à 12).

12. Dispositif selon la revendication 11, caractérisé en ce que le dispositif de commutation (25) est prévu entre le raccordement de diagnostic (17) et les appareils de commande (10 à 12) ou bien sur la ligne de l'appareil de contrôle (20) allant au raccordement de diagnostic (17).

13. Dispositif selon une des revendications 9 à 12, caractérisé en ce qu'il est prévu au moins une fiche d'appareils de commande, qui est munie de broches de codage susceptibles d'être interrogées et contenant des informations sur le degré d'équipement.
